Europäisches Patentamt

European Patent Office

Office européen des brevets

(11) Publication number: **0 150 606**
**B1**

(12) **EUROPEAN PATENT SPECIFICATION**

(45) Date of publication of patent specification: **19.04.89**

(51) Int. Cl.[4]: **H 03 K 5/24,** H 03 F 1/30

(21) Application number: **84308890.7**

(22) Date of filing: **19.12.84**

(54) Comparator circuit.

(30) Priority: **28.12.83 JP 250062/83**

(43) Date of publication of application:
**07.08.85 Bulletin 85/32**

(45) Publication of the grant of the patent:
**19.04.89 Bulletin 89/16**

(84) Designated Contracting States:
**DE FR GB**

(56) References cited:
**EP-A-0 049 024**
**EP-A-0 060 026**
**US-A-4 255 715**

**IEEE JOURNAL OF SOLID-STATE CIRCUITS,
vol. SC-14, no. 6, December 1979, New York,
USA; Y.A HAQUE et al. "A two chip PCM voice
CODEC with filters", pages 961-969**

The file contains technical information
submitted after the application was filed and
not included in this specification

(73) Proprietor: **FUJITSU LIMITED**
**1015, Kamikodanaka Nakahara-ku
Kawasaki-shi Kanagawa 211 (JP)**

(72) Inventor: **Goto, Kunihiko c/o Fujitsu Limited
Patent Department 1015 Kamikodanaka
Nakahara-ku Kawasaki-shi Kanagawa 211 (JP)**
Inventor: **Yamamura, Takeshi c/o Fujitsu
Limited
Patent Department 1015 Kamikodanaka
Nakahara-ku Kawasaki-shi Kanagawa 211 (JP)**

(74) Representative: **Sunderland, James Harry et al
HASELTINE LAKE & CO Hazlitt House 28
Southampton Buildings Chancery Lane
London WC2A 1AT (GB)**

(56) References cited:

**IEEE JOURNAL OF SOLID-STATE CIRCUITS,
vol. SC-17, no. 6, December 1982, New York,
USA; D.J. ALLSTOT "A Precision Variable-
Supply CMOS Comparator", pages 1080-1087**

# Description

The present invention relates to a comparator circuit.

In recent years, a variety of comparator circuits have been widely used in various controlling equipment, for example, as the built-in circuits such as A—D (analog-to-digital) converter, the read-write circuit of a memory device, etc. in the equipment. There are comparator circuits of a type comprising logic ICs such as CMOS inverters or TTL ICs, and of analog type comprising differential amplifiers. For analog type comparators, comparators employing differential operational amplifiers (simply referred to as operational amplifiers, hereinafter) are the most advanced in terms of integration of the circuit involved on a chip, and therefore in terms of cost characteristics.

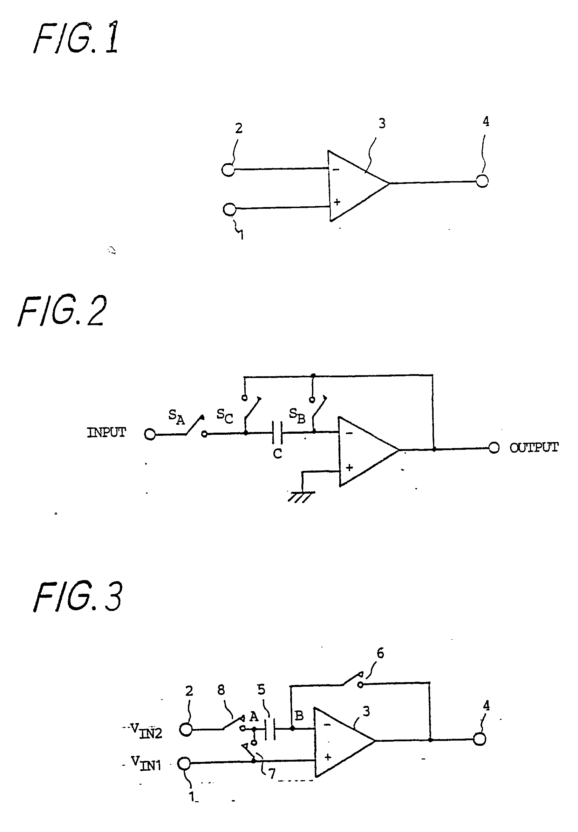

Figure 1 is a schematic circuit diagram of a comparator circuit comprising an operational amplifier 3 with an open-loop circuit. In operation of the comparator of Figure 1, a reference voltage is input to an input terminal 1 connected to a non-inverting input (+) of the operational amplifier 3, and a voltage signal to be compared with the reference voltage is input to an input terminal 2 connected to an inverting input (−) of the operational amplifier 3. The operational amplifier 3 compares the input voltages, and outputs a voltage proportional to the difference between the reference voltage and the signal voltage to an output terminal 4.

The operational amplifier is usually designed so that, when the difference of the two input voltages is 0, the output is at 0 volt. Therefore, in a case where the (reference voltage) level of the non-inverting input (+) is set to be 0 volt, a negative voltage having a value proportional to the absolute value of the signal voltage input to the inverting input (−) is output at the output terminal 4, if the signal voltage is positive, while a positive voltage having a value proportional to the absolute value of the signal voltage is output, if the signal voltage is negative. Thus, whether the input signal voltage is higher than the reference voltage or not can be determined by identifying the polarity of the output signal at the output terminal 4.

However, in general, for operational amplifiers, a so-called offset voltage of a few mV to a few and ten mV appears at the operational amplifier output. On the other hand, there is a requirement for accurate detection (comparison) in relation to a small voltage signal of the order of a few tens to 100 mV, for example, in connection with read-out of data from a memory device or in connection with zero-cross point detection of an analog wave signal for instance. Apparently, the offset voltage places a restriction on the value of detectable signal voltages and reduces accuracy of detection of such small voltage signals.

The offset voltage arises due to characteristic imbalances of circuit elements such as transistors constituting an operational amplifier. That is, the characteristics of a circuit element may deviate from design parameters on account of fluctuations in manufacturing processes, and they also change in dependence upon the operating ambient temperature.

A method of cancelling the effects of such inherent offset voltage in an operational amplifier has been proposed in IEEE Journal of Solid State Circuits, vol. SC-14, No. 6, p. 965, December 1979. In operation of the proposed circuit shown in Figure 2, switches $S_A$ and $S_B$ are initially turned on and a switch $S_C$ is initially turned off. Hence, under these conditions offset voltage on the output of the operational amplifier is fed back to the inverting input (−), and a voltage corresponding to $V_S - V_{OFF}$ is held in a capacitor C, where $V_S$ and $V_{OFF}$ designate signal voltage to input INPUT in Figure 2 and the offset voltage at the output, respectively. Then, the switches $S_A$ and $S_B$ are turned off and the $S_C$ is turned on, and thus, only the signal voltage $V_S$ (a signal of sign and value proportional to $V_S$ as described above) is output from the operational amplifier, because the input voltage $V_S - V_{OFF}$ to the inverting input (−) cancels the offset voltage $V_{OFF}$ standing on the output.

Figure 3 shows a modification of the circuit in Figure 2, in operation of which switches 6 and 7 are initially turned on (and switch 8 is initially turned off) and voltages $V_{IN1}$ and $V_{IN2}$ are input to input terminals 1 and 2, respectively, of operational amplifier 3. Hence voltages at respective nodes A and B become $V_{IN1}$ and $V_{IN1} + V_{OFF}$. This means that $V_{OFF}$ is held in a capacitor 5. When the switches 6 and 7 are turned off and the switch 8 is turned on, the voltage at the node B beomes $V_{IN2} + V_{OFF}$, therefore, its inverted offset voltage component $-V_{OFF}$ cancels the offset voltage $V_{OFF}$ standing on the output 4, and thus, an output voltage corresponding to $V_{IN1} - V_{IN2}$ appears on the output 4.

The above-described method of cancelling the offset voltage by introducing a capacitor connected to the inverting input of the operational amplifier of a comparator circuit is advantageous compared to other previously proposed methods which involve the use of an externally attached resistor, because the "capacitor" method functions independently of the amount (size) of the offset voltage and operational ambient temperature. In previously proposed methods using a resistor, the value of resistor must be selected to match the amount (size) of offset voltage of the individual operational amplifier in use in a comparator circuit and the effects of temperature dependence of the offset voltage cannot be nullified by such methods.

However, the operational amplifier 3 in the circuit of Figure 3 is in voltage follower mode, with negative feedback applied, giving unity voltage gain. Therefore, if delay in the transmission of a signal through the operational amplifier 3 is larger than a time period corresponding to a phase lag of 180° of a signal (an input signal) of frequency f, (i.e. if the delay is larger than 1/2f), the operational amplifier 3 may self-oscillate. It is clear that self-oscillation is more probable as signal frequency increases.

This self-oscillation can be avoided by providing a phase-compensating circuit comprising a capacitor, and this is general in the operational amplifiers except for the comparator application.

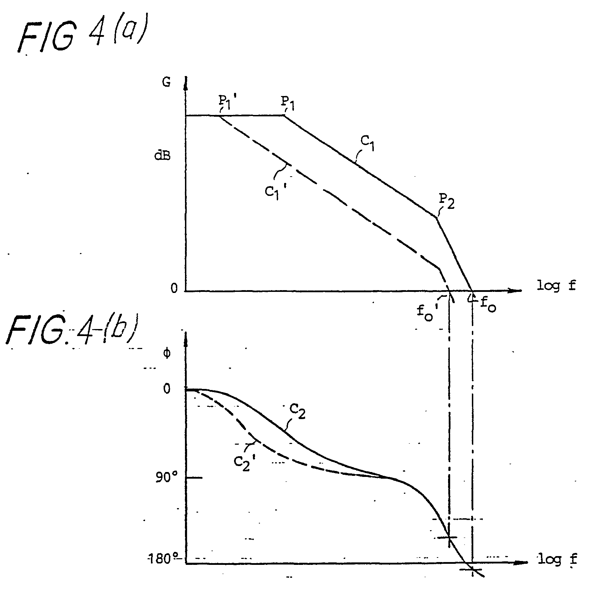

The principle of such phase compensation can be explained by reference to Bode diagrams as shown in Figures 4(a) and 4(b).

Figure 4(a) illustrates the gain (G) − frequency (f) characteristic of an amplifier, represented to logarithmic scales, and Figure 4(b) shows the relationship between the phase angle (φ) in a signal wave and logarithmic frequency (f). In Figure 4(a), P1 and P2 designate so-called poles corresponding to frequencies at which the gain begins to decrease with the rates 6dB/oct and 12dB/oct, respectively.

Referring to Figures 4(a) and 4(b), if the gain (G) of a negative feedback circuit is larger than OdB (i.e. OdB is the case for the voltage follower circuit shown in Figure 3 where the switch 6 is closed) in a frequency range wherein phase angle is equal to or larger than 180°, self-oscillation occurs.

Therefore, to avoid self-oscillation in a negative feedback circuit, the point of intersection of curve C1 and the line of G=0dB must be leftwards (along the frequency axes of Figures 4(a) and 4(b)) with respect to the point of intersection of the curve C2 and the line φ=180°. A phase-compensating circuit is introduced to shift 0dB gain cross point of the curve C1 so as to conform to this requirement.

The phase-compensating circuit is constituted by a negative feedback loop partially applied to an inner circuit (internal circuitry) of the negative feedback circuit, for example, the operational amplifier as shown in Figure 3. If a partial negative feedback loop is applied to the inner circuit (internal circuitry) which determines position of the pole P1, the gain (G) of the negative feedback circuit is reduced as represented by the curve C1', and it intersects the 0dB line at the point corresponding to the frequency fo', lower than fo, the frequency corresponding to the original point of intersection. Thus, the aforementioned condition for avoiding self-oscillation (i.e. G=0dB at a frequency where the corresponding phase angle is smaller than 180°) is achieved. In Figures 4(a) and 4(b), P1' designates the pole, and the curve C2' represents the φ−f characteristic, both newly established when the partial negative feedback is introduced.

The positions of the poles P1 and P1' with regard to frequency are approximately determined by the respective time constants of the inner circuit (internal circuitry) to which the phase-compensating circuit is applied (the time constants of the circuit applicable with and without the phase compensation circuit in place).

Therefore, by introducing a phase-compensating circuit, the response speed of the negative feedback circuit, for example, the operational amplifier as shown in Figure 3, is inevitably decreased.

EP—A2—0 049 024 discloses a comparator circuit switchable between a voltage follower mode and an open loop mode, comprising:

a differential amplifier having two inputs and an output;

a first switching means connected between said output and one of said inputs of said differential amplifier;

an offset voltage compensating capacitor operatively connected to the differential amplifier;

a second switching means; and

a phase compensating capacitor, said phase compensating capacitor being operatively connected to said differential amplifier via said second switching means;

wherein said first and second switching means are arranged and adapted to turn ON and OFF concurrently with one another, whereby said differential amplifier operates in the voltage follower mode when said phase compensating capacitor is made active (when said second switching means is ON), whilst said differential amplifier operates in the open-loop mode when said phase compensating capacitor is made inactive (when said second switching means is OFF).

This comparator circuit, by the provision of the phase compensating capacitor together with the second switching means, is intended to avoid decrease in the response time of the operational amplifier due to the presence of the phase compensating capacitor.

US—A—4 255 715 discloses the use of a latching circuit for latching the output of a comparator circuit.

According to the present invention, there is provided a comparator circuit switchable between a voltage follower mode and an open loop mode, comprising:

a differential amplifier having first and second inputs and an output;

first switching means connected between said output and one of said first and second inputs of said differential amplifier;

an offset voltage compensating capacitor operatively connected to the differential amplifier;

second switching means; and

a phase compensating capacitor, said phase compensating capacitor being operatively connected to said differential amplifier via said second switching means;

the first and second switching means being arranged and adapted to turn ON and OFF concurrently with one another, whereby said differential amplifier operates in the voltage follower mode when said phase compensating capacitor is made active (when said second switching means is ON), whilst said differential amplifier operates in the open-loop mode when said phase compensating capacitor is made inactive (when said second switching means is OFF); characterised in that

the comparator circuit has first and second input terminals for receiving externally applied signals for comparison and comprises:

third switching means operable to switch between a first condition, in which respective connections are established from the first input terminal to the first and second inputs of the differential amplifier one of which connections is by way of the offset voltage compensating capacitor, and a second condition, in which connection from the first input terminal to the second input of the differential amplifier is broken; and

fourth switching means operable to switch between a first condition, in which the second input terminal is disconnected, and a second condition, in which a connection is established from the second input terminal to the second input of the differential amplifier;

the third and fourth switching means being arranged to adopt their first conditions when the first and second switching means are ON and to adapt their second conditions when the first and second switching means are OFF.

An embodiment of the present invention provides a comparator circuit, for comparing the levels of two input signals, operative with high response speed and accuracy.

An embodiment of the present invention provides a comparator circuit operative with a high response speed, free from offset voltage effects and protected from self oscillation.

An embodiment of the present invention provides a comparator circuit capable of detection in relation to a very small input signal.

A comparator circuit in accordance with an embodiment of the present invention can be used in applications in which detection of a small voltage signal wave of few tens or hundreds mV with a frequency of a order of 1 kHz is required, or in which it is necessary to reform such a signal wave.

Reference is made, by way of example, to the accompanying drawings, in which:—

Figure 1 is a schematic circuit diagram showing a comparator circuit comprising an operational amplifier with an open-loop circuit;

Figure 2 is a schematic circuit diagram for assistance in explaining cancellation of offset voltage effects in a comparator circuit comprising an operational amplifier;

Figure 3 is a schematic circuit diagram of a modified form of the circuit shown in Figure 2;

Figures 4(a) and 4(b) are so-called Bode diagrams;

Figure 5 is a schematic circuit diagram of a comparator circuit according to an embodiment of the present invention;

Figure 6 is a schematic circuit diagram of a comparator circuit according to another embodiment of the present invention, modified with respect to the circuit of Figure 5;

Figure 7 is a schematic circuit diagram illustrating an example of internal circuitry which can be employed in the comparator circuits of Figures 5 and 6;

Figure 8(a) is a schematic circuit diagram of another embodiment of the present invention;

Figure 8(b) is a timing chart for assistance in explaining operations of the circuit of Figure 8(a);

Figure 9(a) is a schematic circuit diagram of a comparator circuit according to another embodiment of the present invention; and

Figure 9(b) is a schematic circuit diagram of an example of a switch which can be applied in the comparator circuit of Figure 9(a).

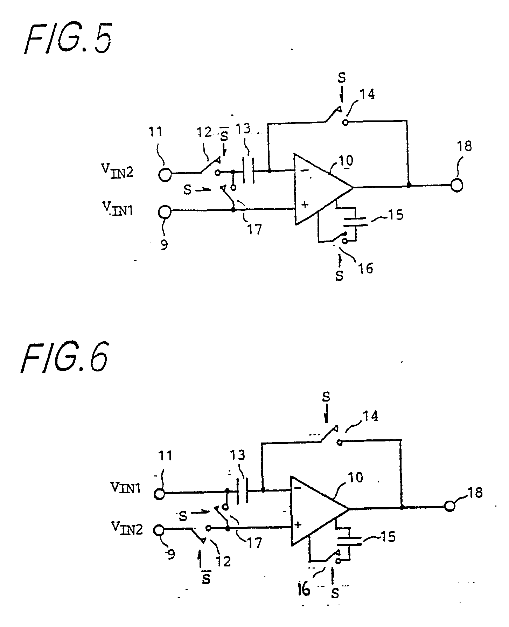

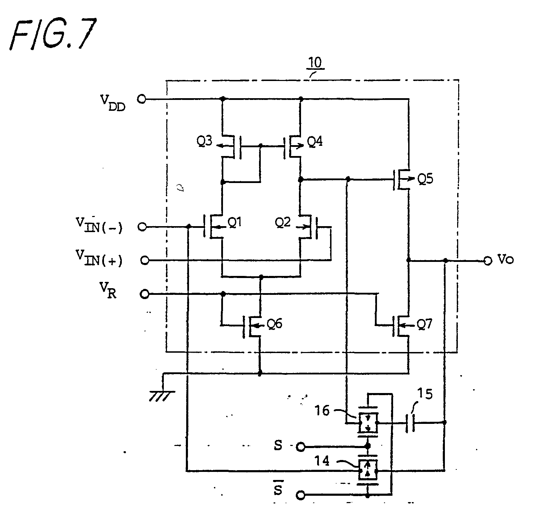

In the schematic circuit diagram of Figure 5, showing a comparator circuit according to an embodiment of the present invention, $V_{IN1}$ is a reference voltage which is input to an input terminal 9 connected to a non-inverting input (+) of an operational amplifier 10, whilst $V_{IN2}$ is a signal voltage, to be compared with the reference voltage $V_{IN1}$, which is input to a terminal 11 connected to an inverting input (−) of the operational amplifier 10 via a switch 12 and a capacitor 13. The capacitor 13 is for holding the offset voltage of the operational amplifier 10, and hence is referred to as the offset voltage compensating capacitor hereinafter. An output 18 of the operational amplifier 10 is connected (via a switch 14) to the inverting input (−) of the amplifier 10 forming a common node (common connection point) with one terminal of the offset voltage compensating capacitor 13. A switch 17 is connected between the node (common connection poont) of the switch 12 and the offset voltage compensating capacitor 13 and the input terminal 9. A serial circuit comprising a capacitor 15 and a switch 16 is connected between other terminals (not shown) of the operational amplifier 10. The capacitor 15 is for compensating phase lag of a signal between the terminals to which the serial circuit is connected and is therefore referred to as the phase compensating capacitor hereinafter.

The operation of the comparator circuit of Figure 5 is as follows.

The switches 14, 16 and 17, each formed from MOS (Metal-Oxide-Semiconductor) transistors for example, operate to turn on and off concurrently with one another, according to an external control signal (indicated by S with an arrow in Figure 5), whilst the switch 12, which is also formed from MOS transistors for example, operates to turn on and off with timing inverse with respect to turn-on and turn-off of the other switches, according to another external control signal indicated by $\overline{S}$ with an arrow in Figure 5. Thus, when 14, 16, 17 are on 12 is off, and when 14, 16, 17 are off 12 is on.

When the switch 12 is turned off and the switches 14, 16 and 17 are turned on, the operational amplifier 10 operates in a voltage follower mode wherein the inverting input (−) is provided with a negative feedback affording unity voltage gain, and only the offset voltage $V_{OFF}$ at the output 18 is held in the offset voltage compensating capacitor 13, because both the non-inverting input (+) of the comparator and the capacitor 13 are now connected to a common potential source, the reference voltage $V_{IN1}$. At the same time, the phase compensating capacitor 15 is made active, and functions to prevent the operational amplifier 10 from self-oscillation in the manner explained with reference to Figures 4(a) and 4(b). This means that the above operation can be stably maintained even when the reference voltage $V_{IN1}$ is a high frequency voltage, of frequency up to fo', the frequency corresponding to the point of intersection of the curve C1' and the 0dB line in Figure 4(a).

Then, when the switch 12 is turned on and the switches 14, 16 and 17 are turned off, the operational amplifier 10 operates in an open-loop mode and the phase compensating capacitor 15 is made inactive. At this time, the inverting input (−) of the operational amplifier 10 receives signal voltage $V_{IN2}$ with superimposition of the offset voltage $V_{OFF}$ held in the offset voltage compensating capacitor 13. That is, $V_{IN2}+V_{OFF}$ is compared with $V_{IN1}$, the reference voltage input to the non-inverting input (+). However, since the inverted output of the above $V_{OFF}$ component cancels the offset voltage $V_{OFF}$ standong on the output 18, a voltage corresponding to the exact difference of $V_{IN2}$ and $V_{IN1}$ appears on the output 18. In this sequence, the phase compensation by capacitor 15 does not function, and the comparison operation is carried out at the highest response speed of the comparator circuit.

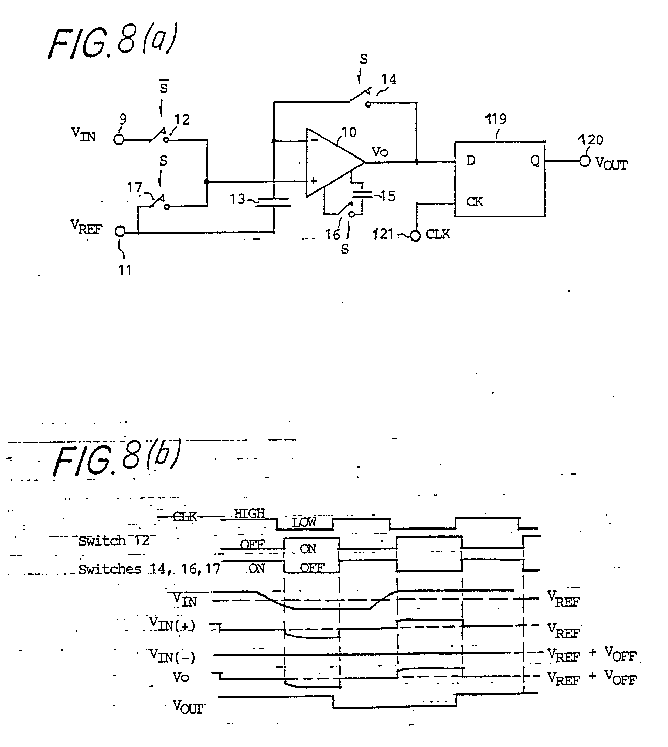

Figure 6 is a schematic circuit diagram of an embodiment of the present invention modified with respect to the comparator circuit shown in Figure 5, wherein the switch 12 is connected between the input terminal 9 and the non-inverting input (+) of the operational amplifier 10, while the input terminal 11 is directly connected to the offset compensating capacitor 13. Different from the circuit of Figure 5, the reference voltage $V_{IN1}$ and signal voltage $V_{IN2}$ are respectively input to input terminals 11 and 9 in Figure 6. However, the operation of the comparator circuit of Figure 6 is essentially the same as that of the circuit shown in Figure 5, except for a difference in the polarity of the output voltage corresponding to the comparison result.

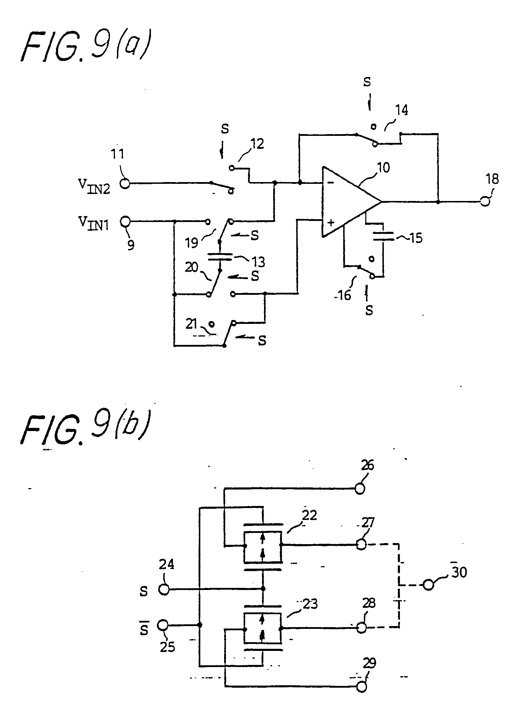

Figure 7 is a schematic circuit diagram showing an example of internal circuitry of the comparator circuit (in particular the operational amplifier) of Figures 5 and 6. Referring to Figure 7, the operational amplifier 10 of Figure 5 or 6 comprises a differential amplifier section formed from transistors Q1 to Q2, and an output amplifier section formed from a transistor Q5. The gates of the transistors Q1 and Q2 are respectively connected to an inverting input $V_{IN}(−)$ and a non-inverting input $V_{IN}(+)$ of the operational amplifier. Transistors Q3 and Q4 constitute respective loads for the transistors Q1 and Q2, and transistors Q6 and Q7, both controlled by a reference voltage $V_R$, constitute respective constant current sources for the differential amplifier section and output amplifier section. $V_o$ is an output of the operational amplifier. $V_{DD}$ is a power supply voltage.

As seen in Figure 7, each of the switches 14 and 16 in Figure 5 or 6 is composed of a pair of transistors, one p-channel and one n-channel, whose conduction channels are connected in parallel to each other. A switch formed in this way is referred to as a transmission gate. When the control signal S and its inverse signal $\overline{S}$ input to the respective gates turn to high level and low level, the switches 14 and 16 are turned on, hence a negative feedback loop from the output Vo to the inverting input $V_{IN}(−)$ and a partial negative feedback loop from the output Vo to the input of the transistor Q5, i.e. the output amplifier, via the phase compensating capacitor 15, are established. On the other hand, when the control signals S and $\overline{S}$ respective turn to low level and high level, the switches 14 and 16 are turned off, and both negative feedback loops are destroyed.

Although the switches 12 and 17 in Figures 5 and 6 are not shown in Figure 7, they also may be composed of transmission gates, similarly to switches 14 and 16.

Figure 8(a) is a circuit diagram showing another embodiment of the present invention, wherein the comparator circuit as shown in Figure 6 is used for reforming an analog signal waveform.

Although in the example of Figure 8(a) the comparator circuit of Figure 6 is used, it will be appreciated that the comparator circuit of Figure 5 can alternatively be used, or any other comparator embodying the present invention.

The operation of the comparator circuit in Figure 8(a) with respect to the input signal $V_{IN}$ and the reference voltage $V_{REF}$ is as explained with reference to Figure 6. Output voltage Vo corresponding to the comparison result is held by a latching circuit 119 which is a D-type flip-flop circuit, for example, and output from a terminal 120. Figure 8(b) is a timing chart for assistance in explaining operations of the waveform reforming circuit of Figure 8(a).

Referring to Figures 8(a) and 8(b), the switches 12, 14, 16 and 17 turn on and off according to a clock signal CLK, wherein only the switch 12 turns off when the clock signal is at high level. An analog voltage signal ($V_{IN}$) is input to the terminal 9, and a reference voltage ($V_{REF}$) is input to the terminal 11. The reference voltage $V_{REF}$ is generally set to be constant, the voltage $V_{IN(−)}$ at the inverting input (−) of the operational amplifier 10 is kept constant at the level $V_{REF}+V_{OFF}$, $V_{OFF}$ being the offset voltage held in the capacitor 13. When the clock signal CLK is in high level, the voltage $V_{IN(+)}$ at the non-inverting input (+) of the operational amplifier 10 is at the level $V_{REF}$. On the other hand, when the clock signal is in low level $V_{IN(+)}$ varies to follow the input signal voltage $V_{IN}$. Therefore, only during a time period when the clock signal CLK is at low level is a voltage wave corresponding to the difference of the analog voltage signal $V_{IN}$ with respect to the reference voltage $V_{REF}$ output as shown by the curve Vo. The latching circuit 119 holds every signal input to its D terminal in accordance with the rise of the clock signal CLK, and outputs a signal wave $V_{OUT}$ from the terminal 120.

Consequently, if the clock signal CLK is controlled so that its repetition frequency $f_{CLK}$ is n times the repetition frequency $f_{VIN}$ of the input analog voltage signal $V_{IN}$ wherein n represents a positive integer, and if the reference voltage $V_{REF}$ is set approximately at the mean voltage of the

analog signal $V_{IN}$, the waveform of the analog voltage signal $V_{IN}$ is reformed as a binary digital signal.

When the repetition frequency of the clock signal is sufficiently large compared to that of the signal to be reformed, it is unnecessary to establish such a strict relationship between $f_{CLK}$ and $f_{VIN}$ as is mentioned above. Such a wave reforming circuit has been practically employed as a slicer in a modem for a multi-channel access system and a personal radio communication system, as disclosed by authors, including the inventors, in the proceedings of the Custom Integrated Circuit Conference held May 1984 in Rochester, New York State, under the title 'A Single Chip 1200 BPS MSK Modem For Multi Channel Access'. In this application, $f_{CLK}$ is approximately 115 kHz, while $f_{VIN}$ is 1.2 to 1.8 kHz.

Figure 9(a) is a circuit diagram showing a further comparator circuit embodying the present invention, and Figure 9(b) is a circuit diagram of an example of a switch applicable to the comparator circuit shown in Figure 9(a). In contrast to the embodiments of the present invention shown in Figures 5, 6, and 8, in the embodiment of Figure 9(a) the offset voltage $V_{OFF}$ held in the offset voltage compensating capacitor 13 is input to the non-inverting input (+) of the operational amplifier 10 during the comparison sequence. For this purpose, switches 19 and 20 acting like a transfer contact in a electro-magnetic relay are employed. In Figure 9(a), although each of the other switches 12, 14, 16 and 21 is shown to be constituted the same as the switches 19 and 20, each of them may, of course, be a single-pole switch.

Figure 9(a) shows the switches in the positions which they take for the voltage follower mode operation of the operational amplifier 10, i.e. for the sequence of charging of the capacitor 13 with the offset voltage. In Figure 9(a), a reference voltage $V_{IN1}$ and a signal voltage $V_{IN2}$ are respectively input to the input terminals 9 and 11. In the same manner as in the operation of the circuit of Figure 5, the output of the operational amplifier 10 is fed back to the inverting input (−) via switch 14, and the offset voltage $V_{OFF}$ is held in the offset voltage compensating capacitor 13. During this charging sequence, the switch 16 is turned on and the phase-compensating capacitor 15 is made active. In the comparison sequence, the switch 12 is turned on, and the signal voltage $V_{IN2}$ is applied to the inverting input (−). At this time, since the switch 21 is turned off, and the switches 19 and 20 are switched to respective positions opposite to those shown in Figure 9(a), the polarity of $V_{OFF}$ as applied from the capacitor 13 to the non-inverting input (+) is inverted with respect to the polarity of $V_{OFF}$ as fed back to the inverting input (−). That is, the reference voltage $V_{REF}$ ($V_{IN1}$) input to the non-inverting input (+) is partially cancelled by the inverted $V_{OFF}$. Therefore, the difference between the input voltage $V_{IN(−)}$ to the inverting input (−) and the input voltage $V_{IN(+)}$ to the non-inverting input (+) is;

$$V_{IN(+)} - V_{IN(−)} = V_{REF} - V_{OFF} - V_{IN2}$$

The inverted $V_{OFF}$ component input to the non-inverting input (+) cancels the $V_{OFF}$ standing on the output of the operational amplifier 10, hence, an exact comparison result corresponding to the difference between the reference voltage $V_{REF}$ and signal voltage $V_{IN2}$ is obtained.

The switches 19 and 20, also the others in Figure 9(a) can be formed from transmission gates 22 and 23, each comprising a couple of FETs (field effect transistors), connected to each other as shown in Figure 9(b). When respective control signals S and its inversion $\bar{S}$ applied to input terminals 24 and 25 of the switch are at high level and low level, respectively, the transmission gate 22 turns off and conduction between terminals 26 and 27 is prevented. At the same time, the transmission gate 23 turns on and conduction between terminals 28 and 29 is established. On the other hand, when the control signals S and $\bar{S}$ are of low level and high level, respectively, the transmission gate 22 is turned on whilst the transmission gate 23 is turned off, and conduction is established and prevented between the respective terminal pairs, 26 and 27, and 28 and 29, oppositely to the above case. By connecting the terminals 27 and 28 to form a common terminal 30, the circuit of Figure 9(b) operates equivalently to an electromagnetic relay having a transfer contact.

It is to be understood that modifications of the above-described embodiments of the present invention can be provided within the scope of the present invention. For example, the reference voltage and the voltage signal may be applied to inverting and non-inverting inputs oppositely to the way in which they are applied in the embodiments of Figures 5, 6, 7, 8(a) and 9(a). For instance, the latching circuit in Figure 8(a) may comprise a flip-flop circuit of a type other than D-type, for example a R—S (reset-set) type or T (trigger) type flip-flop circuit combined with supplemental gate circuits.

In embodiments of the present invention, the reference voltage supplied to one of the input terminals 9, 11 may be ground, for example, or one half the voltage of a positive power source used for operating the comparator circuit, for example.

## Claims

1. A comparator circuit switchable between a voltage follower mode and an open loop mode, comprising:

a differential amplifier (10) having first and second inputs and an output;

first switching means (14) connected between said output and one of said first and second inputs of said differential amplifier (10);

an offset voltage compensating capacitor (13) operatively connected to the differential amplifier;

second switching means (16); and

a phase compensating capacitor (15), said phase compensating capacitor being operatively connected to said differential amplifier (10) via said second switching means (16);

the first (14) and second (16) switching means being arranged and adapted to turn ON and OFF concurrently with one another, whereby said differential amplifier operates in the voltage follower mode when said phase compensating capacitor (15) is made active, when said second switching means (16) is ON, whilst said differential amplifier operates in the open-loop mode when said phase compensating capacitor (15) is made inactive, when said second switching means (16) is OFF; characterised in that

the comparator circuit has first and second input terminals (11, 9) for receiving externally applied signals for comparison ($V_{IN1}$, $V_{IN2}$; $V_{IN(-)}$, $V_{IN(+)}$; $V_{IN}$, $V_{REF}$) and comprises:

third switching means (17; 19, 20, 21), operable to switch between a first condition, in which respective connections are established from the first input terminal to the first and second inputs of the differential amplifier one of which connections is by way of the offset voltage compensating capacitor (13), and a second condition, in which connection from the first input terminal to the second input of the differential amplifier is broken; and

fourth switching means (12) operable to switch between a first condition, in which the second input terminal is disconnected, and a second condition, in which a connection is established from the second input terminal to the second input of the differential amplifier;

the third and fourth switching means (17; 19, 20, 21) being arranged to adaopt their first conditions when the first and second switching means are ON and to adopt their second conditions when the first and second switching means are OFF.

2. A comparator circuit as claimed in claim 1, wherein one end of the offset voltage compensating capacitor (13) is connected to the second input of the differential amplifier (10), the first input terminal is connected to the first input of the differential amplifier (10), the third switching means (17) are connected between the first input of the differential amplifier (10) and the other end of the offset voltage compensating capacitor (13), and the fourth switching means (12) are connected between the other end of the offset voltage compensating capacity (13) and the second input terminal.

3. A comparator circuit as claimed in claim 1, wherein one end of the offset voltage compensating capacitor (13) is connected to the first input of the differential amplifier (10), the first input terminal is connected to the other end of the offset voltage compensating capacitor (13), the third switching means (17) are connected between the second input of the differential amplifier (10) and the other end of the offset voltage compensating capacitor (13), and the fourth switching means (12) are connected between the second input of the differential amplifier (10) and the second input terminal.

4. A comparator circuit as claimed in claim 1, wherein the third switching means comprises first (19), second (20) and third (21) switches,

the first switch (19) being switchable to connect one end of the offset voltage compensating capacitor to the second input of the differential amplifier (10) or to the first input terminal;

the second switch (20) being switchable to connect the other end of said offset compensating capacitor (13) to the first input terminal or to the first input of the differential amplifier (10); and

the third switch (21) being switchable to connect the first input terminal to, or disconnect the first input terminal from, the first input of the differential amplifier (10);

wherein the first switch (19) is operable to connect said one end of said offset voltage compensating capacitor to the second input of the differential amplifier, the second switch (20) is operable to connect said other end of said offset voltage compensating capacitor to the first input terminal, and the third switch (21) is operable to connect the first input of said differential amplifier to the first input terminal, during the voltage follower mode of operation of the differential amplifier, whilst the first switch (19) is operable to connect said one end of the offset voltage compensating capacitor to the first input terminal, the second switch (20) is operable to connect said other end of the offset voltage compensating capacitor to said first input of the differential amplifier, and the third switch (21) is operable to disconnect the first input of the differential amplifier from the first input terminal during the open-loop mode of operation of said differential amplifier.

5. A comparator circuit as claimed in any preceding claim, further comprising:

a latching circuit for latching the result of comparison performed by said differential amplifier.

6. A comparator circuit as claimed in any preceding claim, wherein each of said first and second switching means is a transmission gate.

7. A comparator circuit as claimed in any preceding claim, wherein of the first and second inputs of said differential amplifier one is an inverting input and the other a non-inverting input.

8. A comparator circuit as claimed in claim 7, wherein said non-inverting input is operatively connected to a reference voltage source.

9. A comparator circuit as claimed in claim 7, wherein said inverting input is operatively connected to a reference voltage source.

10. A comparator circuit as claimed in claim 8 or 9, wherein the value of said reference voltage is one half of a positive power source voltage.

11. A comparator circuit as claimed in claim 8 or 9, wherein said reference voltage is ground potential.

12. A comparator circuit as claimed in claim 4, wherein each of said first and second switches comprises a pair of transmission gates having a pair of common gates, each of the common gates consisting of a gate of a p-channel transistor in one of said transmission gates and a gate of an n-channel transistor in the other of said transmission gates.

**Patentansprüche**

1. Komparatorschaltung, die zwischen einem Spannungsfolgermodus und einem Steuerkreismodus umschaltbar ist, mit:

einem Differenzverstärker (10), der erste und zweite Eingänge und einen Ausgang hat;

einer ersten Schalteinrichtung (14), die zwischen dem genannten Ausgang und einem von den genannten ersten und zweiten Eingängen des genannten Differenzverstärkers (10) verbunden ist;

einem Versetzungsspannungs - Kompensationskondensator (13), der wirkungsmäßig mit dem Differenzverstärker verbunden ist;

einer zweiten Schalteinrichtung (16); und

einem Phasenkompensationskondensator (15), welcher Phasenkompensationskondensator wirkungsmäßig mit dem genannten Differenzverstärker (10) über die genannte zweite Schalteinrichtung (16) verbunden ist;

wobei die erste (14) und zweite (16) Schalteinrichtung angeordnet und angepaßt sind, um gleichzeitig miteinander EIN und AUS zu schalten, wodurch der genannte Differenzverstärker in dem Spannungsfolgermodus arbeitet, wenn der genannte Phasenkomponensationskondensator (15) aktiv gemacht ist, wenn die genannte zweite Schalteinrichtung (16) EIN ist, wohingegen der genannte Differenzverstärker in dem Steuerkreismodus arbeitet, wenn der genannte Phasenkompensationskondensator (15) inaktiv gemacht ist, wenn die genannte zweite Schalteinrichtung (16) AUS ist; dadurch gekennzeichnet, daß

die Komparatorschaltung erste und zweite Eingangsanschlüsse (11, 9) hat, zum Empfang von extern zugeführten Signalen für den Vergleich ($V_{IN1}$, $V_{IN2}$; $V_{IN(-)}$, $V_{IN(+)}$; $V_{IN}$, $V_{REF}$), und umfaßt:

dritte Schalteinrichtungen (17; 19, 20, 21), die betreibbar sind, um zwischen einem ersten Zustand, in welchem die jeweiligen Verbindungen von dem ersten Eingangsanschluß zu den ersten und zweiten Eingängen des Differenzverstärkers hergestellt werden, von denen eine Verbindung über den Versetzungsspannungs - Kompensationskondensators (13) ist, und einem zweiten Zustand, bei dem die Verbindung von dem genannten ersten Eingangsanschluß zu dem zweiten Eingang des Differenzverstärkers unterbrochen ist, zu schalten; und

vierte Schalteinrichtungen (12), die betreibbar sind, um zwischen einem ersten Zustand, bei dem der zweite Eingangsanschluß abgetrennt ist, und einem zweiten Zustand, bei dem eine Verbindung zwischen dem zweiten Eingangsanschluß und dem zweiten Eingang des Differenzverstärkers hergestellt ist, zu schalten;

dritte und vierte Schalteinrichtungen (17; 19, 20, 21) angeordnet sind, um ihre ersten Zustände einzunehmen, wenn die ersten und die zweiten Schalteinrichtungen EIN sind, und ihre zweiten Zustände einnehmen, wenn die erste und die zweite Schalteinrichtungen AUS sind.

2. Komparatorschaltung nach Anspruch 1, bei der ein Ende des Versetzungsspannungs - Kompensationskondensators (13) mit dem zweiten Eingang des Differenzverstärkers (10) verbunden ist, der erste Einganganschluß mit dem ersten Eingang des Differenzverstärkers (10) verbunden ist, die dritte Schalteinrichtung (17) zwischen dem ersten Eingang des Differenzverstärkes (10) und dem anderen Ende des Versetzungsspannungs - Kompensationskondensators (13) verbunden ist, und die vierte Schalteinrichtung (12) zwischen dem anderen Ende der Versetzungsspannungs - Kompensationskapazität (13) und dem zweiten Eingangsanschluß verbunden ist.

3. Komparatorschaltung nach Anspruch 1, bei der ein Ende des Versetzungsspannungs - Kompensationskondensators (13) mit dem ersten Eingang des Differenzverstärkers (10) verbunden ist, der erste Eingangsanschluß mit dem anderen Ende des Versetzungsspannungs - Kompensationskondensators (13) verbunden ist, die dritte Schalteinrichtung (17) zwischen dem zweiten Eingang des Differenzverstärkers (10) und dem anderen Ende des Versetzungsspannungs - Kompensationskondensators (13) verbunden ist, und die vierte Schalteinrichtung (12) zwischen dem zweiten Eingang des Differenzverstärkes (10) und dem zweiten Eingangsanschluß verbunden ist.

4. Komparatorschaltung nach Anspruch 1, bei der die dritte Schalteinrichtung erste (19), zweite (20) und dritte (21) Schalter umfaßt,

der erste Schalter (19) schaltbar ist, um eine Ende des Versetzungsspannungs - Kompensationskondensators mit dem zweiten Eingang des Differenzverstärkers (10) oder mit dem ersten Eingangsanschluß zu verbinden;

der zweite Schalter (20) schaltbar ist, um das andere Ende des genannten Versetzungs - Kompensationskondensators (13) mit dem ersten Eingangsanschluß oder dem ersten Eingang des Differenzverstärkers (10) zu verbinden; und

der dritte Schalter (21) schaltbar ist, um den ersten Eingangsanschluß mit dem ersten Eingang des Differenzverstärkers (10) zu verbinden oder ihn von diesem zu trennen;

bei der der erste Schalter (19) betreibbar ist, um das genannte eine Ende des genannten Versetzungsspannungs - Kompensationskondensators mit dem zweiten Eingang des Differenzverstärkers zu verbinden, der zweite Schalter (20) betreibbar ist, um das genannte anderer Ende des genannten Versetzungsspannungs - Kompensationskondensators mit dem ersten Eingangsanschluß zu verbinden, und der dritte Schalter (21) betreibbar ist, um den ersten Eingang des genannten Differenzverstärkers, während des Spannungsfolgermodus des Betriebs des Differenzverstärkers, mit dem ersten Eingangsanschluß zu verbinden, während der erste Schalter (19) betreibbar ist, um das genannte eine Ende

des Versetzungsspannungs - Kompensationskondensators mit dem ersten Eingangsanschluß zu verbinden, und der zweite Schalter (20) betreibbar ist, um das genannte andere Ende des Versetzungsspannungs - Kompensationskondensators mit dem genannten ersten Eingang des Differenzverstärkers zu verbinden, und der dritte Schalter (21) betreibbar ist, um den ersten Eingang des Differenzverstärkers während des Steuerkreismodus des Bretriebes des Differenzverstärkers von dem ersten Eingangsanschluß zu trennen.

5. Komparatorschaltung nach einem der vorhergehenden Ansprüche, ferner mit

einer Halteschaltung zum Halten des Ergebnisses des Vergleiches, der von dem genannten Differenzverstärker ausgeführt wird.

6. Komparatorschaltung nach einem der vorhergehenden Ansprüche, bei der jede der ersten und zweiten Schalteinrichtungen ein Transmissionsgate ist.

7. Komparatorschaltung nach einem der vorhergehenden Ansprüche, bei der von den ersten und zweiten Eingängen des genannten Differenzverstärkers einer ein invertierender Eingang und der andere ein nicht invertierender Eingang ist.

8. Komparatorschaltung nach Anspruch 7, bei der der genannte nichtinvertierende Eingang wirkungsmäßig mit einer Referenzspannungsquelle verbunden ist.

9. Komparatorschaltung nach Anspruch 7, bei der der genannte invertierende Eingang wirkungsmäßig mit einer Referenzspannungsquelle verbunden ist.

10. Komparatorschaltung nach Anspruch 8 oder 9, bei der der Wert der genannten Referenzspannung die Hälfte einer positiven Energiequellenspannung ist.

11. Komparatorschaltung nach Anspruch 8 oder 9, bei der die genannte Referenzspannung Erdpotential ist.

12. Komparatorschaltung nach Anspruch 4, bei der jeder der genannten ersten und zweiten Schalter ein Paar von Transmissionsgates umfaßt, die ein Paar von gemeinsamen Gates haben, wobei jedes der gemeinsamen Gates aus einem Gate von einem p - Kanal - Transistor in einem der genannten Transmissionsgates und einem Gate von einem n - Kanal - Transistor in dem anderen der genannten Transmissionsgates besteht.

**Revendications**

1. Un circuit comparateur pouvant être commuté entre un mode suiveur de tension et un mode en boucle ouverte, comprenant:

un amplificateur différentiel (10) ayant des première et seconde entrées et une sortie;

des premiers moyens de commutation (14) connectés entre la sortie et l'une des première et seconde entrées de l'amplificateur différentiel (10);

un condensateur de compensation de tension de décalage (13) connecté fonctionnellement à l'amplificateur différentiel;

des seconds moyens de commutation (16); et

un condensateur de compensation de phase (15), ce condensateur de compensation de phase étant connecté fonctionnellement à l'amplificateur différentiel (10) par l'intermédiaire des seconds moyens de commutation (16);

les premiers (14) et seconds (16) moyens de commutation étant conçus de façon à se fermer et à s'ouvrir simultanément, grâce à quoi l'amplificateur différentiel fonctionne dans le mode suiveur de tension lorsque le condensateur de compensation de phase (15) est placé à l'état actif, lorsque les seconds moyens de commutation (16) sont fermés, tandis que l'amplificateur différentiel fonctionne dans le mode en boucle ouverte lorsque le condensateur de compensation de phase (15) est placé à l'état actif, lorsque les seconds moyens de compensation (16) sont ouverts; caractérisé en ce que

le circuit comparateur comporte des première et seconde bornes d'entrée (11, 9) pour recevoir des signaux appliqués de façon externe dans un but de comparaison ($V_{IN1}$, $V_{IN2}$; $V_{IN(-)}$, $V_{IN(+)}$; $V_{IN}$, $V_{REF}$), et il comprend:

des troisièmes moyens de commutation (17; 19, 20, 21) qui sont capables de commuter entre une première conditions, dans laquelle des connexions respectives sont établies de la première borne d'entrée vers les première et seconde entrées de l'amplificateur différentiel, l'une de ces connexion passant par le condensateur de compensation de tension de décalage (13), et une seconde condition, dans laquelle la connexion de la première borne d'entrée vers la seconde entrée de l'amplificateur différentiel est rompue; et

des quatrièmes moyens de commutation (12) capables de commuter entre une première condition, dans laquelle la seconde borne d'entrée est déconnectée, et une seconde condition dans laquelle une connexion est établie de la seconde borne d'entrée vers le seconde entrée de l'amplificateur différentiel;

les troisièmes et quatrièmes moyens de commutation (17; 19, 20, 21) étant conçus de façon à prendre leurs premières conditions lorsque les premiers et seconds moyens de commutation sont fermés, et à prendre leurs secondes conditions lorsque les premiers et seconds moyens de commutation sont à l'état ouvert.

2. Un circuit comparateur selon la revendication 1, dans lequel une borne du condensateur de compensation de tension de décalage (13) est connectée à la seconde entrée de l'amplificateur différentiel (10), la première borne d'entrée est connectée à la première entrée de l'amplificateur différentiel (10), les troisièmes moyens de commutation (17) sont connectés entre la première entrée de l'amplificateur différentiel (10) et l'autre borne du condensateur de, compensation de tension de décalage (13), et les quatrièmes moyens de commutation (12) sont connectés entre l'autre borne du condensateur de compensation de tension de décalage (13) et la seconde borne d'entrée.

3. Un circuit comparateur selon la revendication 1, dans lequel une borne du condensateur de compensation de tension de décalage (13) est connectée à la première entrée de l'amplificateur différentiel (10), la première borne d'entrée est connectée à l'autre borne du condensateur de compensation de tension de décalage (13), les troisièmes moyens de commutation (17) sont connectés entre la second entrée de l'amplificateur différentiel (10) et l'autre borne du condensateur de compensation de tension de décalage (13), et les quatrièmes moyens de commutation (12) sont connectés entre la seconde entrée de l'amplificateur différentiel (10) et la seconde borne d'entrée.

4. Un circuit comparateur selon la revendication 1, dans lequel les troisièmes moyens de commutation comprennent des premier (19), second (20) et troisième (21) commutateurs,

le premier commutateur (19) peut être commuté de façon à connecter une borne du condensateur de compensation de tension de décalage à la seconde entrée de l'amplificateur différentiel (10) ou à la première borne d'entrée;

le second commutateur (20) peut être commuté de façon à connecter l'autre boren du condensateur de compensation de tension de décalage (13) à la première borne d'entrée ou à la première entrée de l'amplificateur différentiel (10); et

le troisième commutateur (21) peut être commuté de façon à connecter la première borne d'entrée à la première entrée de l'amplificateur différentiel (10), ou à déconnecter la première borne d'entrée de la première entrée de l'amplificateur différentiel;

dans lequel le premier commutateur (19) peut connecter la borne précitée du condensateur de compensation de tension de décalage à la seconde entrée de l'amplificateur différentiel, le second commutateur (20) peut connecter l'autre borne du condensateur de compensation de tension de décalage à la première borne d'entrée, et le troisième commutateur (21) peut connecter la première entrée de l'amplificateur différentiel à la première borne d'entrée, pendant le mode de fonctionnement suiveur de tension de l'amplificateur différentiel, tandis que le premier commutateur (19) peut connecter la borne précitée du condensateur de compensation de tension à la première entrée, le second commutateur (20) peut connecter l'autre borne du condensateur de compensation de tension de décalage à la première entrée de l'amplificateur différentiel, et le troisième commutateur (20) peut déconnecter la première entrée de l'amplificateur différentiel vis-à-vis de la première borne d'entrée, pendant le mode de fonctionnement en boucle ouverte de l'amplificateur différentiel.

5. Un circuit selon l'une quelconque des revendications précédentes, comprenant en outre:

un circuit de mémorisation pour mémoriser le résultat de la comparaison qui est effectuée par l'amplificateur différentiel.

6. Un circuit comparateur selon l'une quelconque des revendications précédentes, dans lequel chacun des premiers et seconds moyens de commutation consiste en une porte de transmission.

7. Un circuit comparateur selon l'une quelconque des revendications précédentes, dans lequel parmi les première et seconde entrées de l'amplificateur différentiel, l'une est une entrée inverseuse et l'autre une entrée non inverseuse.

8. Un circuit comparateur selon la revendication 7, dans lequel l'entrée non inverseuse est connectée fonctionellement à une source de tension de référence.

9. Un circuit comparateur selon la revendication 7, dans lequel l'entrée inverseuse est connectée fonctionnellement à une source de tension de référence.

10. Un circuit comparateur selon la revendication 8 ou 9, dans lequel la valeur de la tension de référence est égale à la moitié d'une tension de source d'alimentation positive.

11. Un circuit comparateur selon la revendication 8 ou 9, dans lequel la tension de référence est égale au potentiel de la masse.

12. Un circuit comparateur selon la revendication 4, dans lequel chacun des premiers et seconds commutateurs comprend une paire de portes de transmission ayant une paire de grilles communes, et les grilles communes comprennent une grille d'un transistor à canal p dans l'une des portes de transmission, et une grille d'un transistor à canal n dans l'autre porte de transmission.

*FIG.1*

*FIG.2*

INPUT

OUTPUT

*FIG.3*

$V_{IN2}$

$V_{IN1}$

FIG 4 (a)

FIG. 4-(b)

*FIG.5*

*FIG.6*

*FIG.7*

# FIG.8 (a)

# FIG.8 (b)

# FIG. 9 (a)

# FIG. 9 (b)